# EUROPEAN PATENT APPLICATION

(11) **EP 4 593 523 A1**
(43) Date of publication of application: **30.07.2025**
(21) Application number: 22963853.1
(22) Date of filing: 02.11.2022
(51) Int. Cl.: H04W 88/08, H04B 1/38

(54) **RADIO FREQUENCY POWER AMPLIFIER, REMOTE RADIO UNIT, AND BASE STATION**

(71) Applicant: Huawei Technologies Co., Ltd., Shenzhen, Guangdong 518129 (CN)
(72) Inventor: SUN, Jie, Shenzhen, Guangdong 518129 (CN); XUE, Yujie, Shenzhen, Guangdong 518129 (CN); CHEN, Jinhu, Shenzhen, Guangdong 518129 (CN); SUN, Yijun, Shenzhen, Guangdong 518129 (CN); LI, Ke, Shenzhen, Guangdong 518129 (CN); YANG, Maoqing, Shenzhen, Guangdong 518129 (CN)
(74) Representative: Thun, Clemens
(86) International application number: PCT/CN2022/129119
(87) International publication number: WO 2024/092535

(57) **Abstract**

This application discloses a radio frequency power amplifier, a remote radio unit, and a base station. The radio frequency power amplifier includes three amplification branches, where two amplification branches have narrow working frequency bands and respectively work on a frequency band A and a frequency band B, and the other amplification branch is designed to have a wide frequency band and works in a frequency band A+B. The radio frequency power amplifier further includes an inter-frequency power division circuit and two circulators. The inter-frequency power division circuit performs inter-frequency power division on an output signal of a wideband amplification branch to output two paths of narrowband signals, and the two paths of narrowband signals are output after being respectively subject to power combination with output signals of each narrowband amplification branch by the circulators. Based on the technical solution of this application, a wideband issue is converted into a narrowband issue, so that power amplification efficiency is improved; and the wideband amplification branch provides a power sharing function, thereby implementing processing of a high-power wideband signal. A narrowband isolator is used at a lower level of the circulators, so that design difficulty of the isolator is reduced.

## Description

### TECHNICAL FIELD

This application relates to the communication device technology field, and in particular, to a radio frequency power amplifier, a remote radio unit, and a base station.

### BACKGROUND

As spectrum resources of wireless communication are scarce, to improve spectrum utilization, a complex modulation scheme is widely applied to communication systems. In this case, a peak-to-average ratio of a modulation signal is very high. For example, in a 5G communication system, even if peak clipping processing is performed, a signal peak-to-average ratio is still as high as 9.5 dB. With such a large power back-off area, a conventional power amplifier (PA for short below) usually faces a problem of low back-off efficiency. In addition, in most service scenarios on the live network, a number of user services is not large, and the PA usually works in a larger back-off state. In this case for the PA, efficiency is low and power consumption is high. Therefore, a new challenge is brought to power amplifiers in base stations. Current and future wireless communication systems urgently require that PAs have higher efficiency under higher power back-off. In addition, to meet requirements of high rate and low delay of current and future communication, signal bandwidths are increasingly wider, and spectrums of wireless communication systems are fragmented, requiring PAs to support a wideband multi-frequency feature. Therefore, with development of the wireless communication system, power amplifiers of base stations need to support an ultra-wideband feature and achieve high efficiency.

At present, it is very challenging for a PA, especially a high-power PA, of a base station to implement ultra-wideband and high efficiency. In addition to a conflict between the bandwidth and back-off of the PA, another reason lies in the fact that, an output power increase of the PA leads to a size increase of an internal power tube. In this case, due to reasons such as a parasitic parameter and a higher impedance conversion ratio, a working bandwidth of the power tube decreases.

In addition, an isolator is an important component of the PA, especially an isolator cascaded to a final output end of the PA. A function of a final isolator is to ensure that PA performance is not affected by a mismatch of an antenna and the like. However, in an ultra-wideband PA design, for example, a relative bandwidth of 1.8 to 2.7 GHz is as accounts for 40%, and an ultra-wideband isolator is usually faced with problems such as a large insertion loss and a poor linear indicator.

### SUMMARY

To resolve the foregoing technical problems, this application provides a radio frequency power amplifier, a remote radio unit, and a base station, which are configured to implement an ultra-wideband feature and achieve high efficiency, and are particularly suitable for a high-power ultra-wideband energy-saving scenario.

The radio frequency power amplifier provided in this application does not specifically limit a quantity of input signal paths, for example, the quantity may be N, where N is an integer greater than or equal to 3. The radio frequency power amplifier may include N amplification branches, N-1 circulators, and at least one inter-frequency power division circuit. For example, the radio frequency power amplifier includes: three amplification branches, two circulators, and one inter-frequency power division circuit. The three amplification branches are respectively configured to input three paths of signals. An output end of a third amplification branch is connected to an input end of a first inter-frequency power division circuit. A working frequency band of the first amplification branch and a first circulator is a frequency band A, a working frequency band of a second amplification branch and a second circulator is a frequency band B, and a working frequency band of the third amplification branch is the frequency band A and the frequency band B. The first inter-frequency power division circuit outputs a frequency band A signal and a frequency band B signal. An output end of the first amplification branch and a first output end of the first inter-frequency power division circuit are respectively connected to different ports of the first circulator, and the first circulator performs power combination on a frequency band A signal output by the first amplification branch and the frequency band A signal output by the first inter-frequency power division circuit, and then performs output. An output end of the second amplification branch and a second output end of the first inter-frequency power division circuit are respectively connected to different ports of the second circulator, and the second circulator performs power combination on a frequency band B signal output by the second amplification branch and the frequency band B signal output by the first inter-frequency power division circuit, and then performs output.

The frequency band A and the frequency band B described in the foregoing embodiment of this application may be a single frequency band, or may be a plurality of frequency bands. The frequency band A and the frequency band B are different frequency bands. In other words, the frequency band A and the frequency band B do not have an overlapping frequency band range, that is, the two frequency bands do not have an overlapping frequency. A frequency of the frequency band A may be greater than that of the frequency band B, or a frequency of the frequency band A may be less than that of the frequency band B.

In the radio frequency power amplifier, two amplification branches have narrow working frequency bands and respectively work on the frequency band A and the frequency band B, and the other amplification branch is designed to have a wide frequency band and works in a frequency band A+B. The radio frequency power amplifier further includes an inter-frequency power division circuit and two circulators. The inter-frequency power division circuit performs inter-frequency power division on an output signal of the wideband amplification branch to output two paths of narrowband signals, and the two paths of narrowband signals are output after being respectively subject to power combination with output signals of each narrowband amplification branch by the circulators. Based on the technical solution of this application, a wideband issue is converted into a narrowband issue and a PA with a narrow bandwidth is used for implementation, so that PA efficiency is improved; and the wideband amplification branch provides a power sharing function, thereby implementing processing of a high-power wideband signal. In addition, a narrowband isolator is used at a lower level of each circulator, so that an isolator with a wide bandwidth is not required, and design difficulty of the isolator is reduced.

A port type of a circulator connected to the first inter-frequency power division circuit is not specifically limited in this application. Herein, the port type of the circulator indicates an isolation port or an input port. The first inter-frequency power division circuit may be connected to the isolation port of the circulator, or may be connected to the input port of the circulator. The following describes several possible implementations.

In a possible implementation, the output end of the first amplification branch is connected to an isolation port of the first circulator; the first output end of the first inter-frequency power division circuit is connected to an input port of the first circulator; the output end of the second amplification branch is connected to an isolation port of the second circulator; and the second output end of the first inter-frequency power division circuit is connected to an input port of the second circulator. As amplification branches are connected to the isolation ports of the circulators, output loads of the amplification branches remain unchanged, facilitating an independent design, and a working bandwidth may be relatively wide.

In a possible implementation, the output end of the first amplification branch is connected to an input port of the first circulator; the first output end of the first inter-frequency power division circuit is connected to an isolation port of the first circulator; the output end of the second amplification branch is connected to an input port of the second circulator; and the second output end of the first inter-frequency power division circuit is connected to an isolation port of the second circulator. As the first inter-frequency power division circuit is connected to the isolation ports of the circulators, an output load of the first inter-frequency power division circuit remains unchanged, facilitating an independent design of the third amplification branch and the first inter-frequency power division circuit.

In a possible implementation, the output end of the first amplification branch is connected to an input port of the first circulator; the first output end of the first inter-frequency power division circuit is connected to an isolation port of the first circulator; the output end of the second amplification branch is connected to an isolation port of the second circulator; and the second output end of the first inter-frequency power division circuit is connected to an input port of the second circulator.

In a possible implementation, the output end of the first amplification branch is connected to an isolation port of the first circulator; the first output end of the first inter-frequency power division circuit is connected to an input port of the first circulator; the output end of the second amplification branch is connected to an input port of the second circulator; and the second output end of the first inter-frequency power division circuit is connected to an isolation port of the second circulator.

A specific implementation of each amplification branch is not specifically limited in this application. For example, the first amplification branch, the second amplification branch, and the third amplification branch are any one of the following: a single-transistor PA, a Doherty PA, a Chireix PA, a timing Doherty PA, a load modulated balanced amplifier LMBA, or a circulator load modulated amplifier CLMA.

The following respectively describes several specific implementations of each amplification branch.

In a first implementation, the first amplification branch, the second amplification branch, and the third amplification branch each include the single-transistor PA. The single-transistor PA included in the first amplification branch is a first carrier PA, the single-transistor PA included in the second amplification branch is a second carrier PA, and the single-transistor PA included in the third amplification branch is a peak PA.

In a second implementation, the first amplification branch and the second amplification branch each include the Doherty PA, the third amplification branch includes the single-transistor PA, and the single-transistor PA included in the third amplification branch is a peak PA.

In a third implementation, the first amplification branch, the second amplification branch, and the third amplification branch each include the Doherty PA.

The foregoing describes implementations of three paths of input signals. The following describes an implementation of one path of signal. In a possible implementation, the radio frequency power amplifier further includes: a second inter-frequency power division circuit, a power splitter, and a phase compensation network. A first output end of the power splitter is connected to an input end of the second inter-frequency power division circuit, a first output end and a second output end of the second inter-frequency power division circuit are respectively connected to the first amplification branch and the second amplification branch, a second output end of the power splitter is connected to a first end of the phase compensation network, and a second end of the phase compensation network is connected to the third amplification branch.

Based on the foregoing method of one path of input signal, the following describes an implementation of one path of output signal. In a possible implementation, the radio frequency power amplifier further includes a third inter-frequency power division circuit. An output end of the first circulator and an output end of the second circulator are respectively connected to a first input end and a second input end of the third inter-frequency power division circuit, and the third inter-frequency power division circuit outputs a signal obtained through power combination.

The foregoing describes the radio frequency power amplifier with three paths of input signals. The following describes an implementation of the radio frequency power amplifier corresponding to more paths of input signals. A quantity of input signal paths is not specifically limited in this application. In a possible implementation, the radio frequency power amplifier further includes a fourth amplification branch and a third circulator. The third amplification branch works on the frequency band A, the frequency band B, and a frequency band C. An input end of the fourth amplification branch is configured to connect to a fourth path of signal. An output end of the fourth amplification branch and a third output end of the first inter-frequency power division circuit are respectively connected to different ports of the third circulator, and the first inter-frequency power division circuit is further configured to output a frequency band C signal. The third circulator is configured to: perform power combination on a frequency band C signal output by the fourth amplification branch and the frequency band C signal output by the first inter-frequency power division circuit, and then perform output.

The radio frequency power amplifiers provided above can work in both a frequency division duplex mode and a time division duplex mode. The following describes an implementation of the time division duplex mode. Switch between a signal transmit channel and a signal receive channel can be implemented by adding two switches.

In a first implementation, the radio frequency power amplifier further includes a first switch and a second switch. An antenna port of the first switch is connected to the isolation port of the first circulator, a receive port of the first switch is connected to a corresponding receive channel, and a transmit port of the first switch is connected to the output end of the first amplification branch. An antenna port of the second switch is connected to the isolation port of the second circulator, and a receive port of the second switch is connected to a corresponding receive channel. A transmit port of the second switch is connected to the second amplification branch.

In a second implementation, the radio frequency power amplifier further includes: a first switch and a second switch. An antenna port of the first switch is connected to the isolation port of a first circulator, a receive port of the first switch is connected to a corresponding receive channel, and a transmit port of the first switch is connected to the first output end of the first inter-frequency power division circuit. An antenna port of the second switch is connected to the isolation port of the second circulator, a receive port of the second switch is connected to a corresponding receive channel, and a transmit port of the second switch is connected to the second output end of the first inter-frequency power division circuit.

This application further provides a remote radio unit, including the radio frequency power amplifier described above, and further including a duplexer. An end of the radio frequency power amplifier is connected to the duplexer.

This application further provides a base station, including the remote radio unit described above, and further including an antenna. The remote radio unit is connected to the antenna, and the remote radio unit is configured to process received and transmitted signals of the antenna.

This application has at least the following advantages:

The radio frequency power amplifier includes three amplification branches, where two amplification branches have narrow working frequency bands and respectively work on the frequency band A and the frequency band B, and the other amplification branch is designed to have a wide frequency band and works in the frequency band A+B, that is, a working frequency band of the other amplification branch covers the frequency band A and the frequency band B. The radio frequency power amplifier further includes an inter-frequency power division circuit and two circulators. The inter-frequency power division circuit may perform inter-frequency power division on an output signal of a wideband amplification branch to output two paths of narrowband signals, and the two paths of narrowband signals are output after being respectively subject to power combination with output signals of each narrowband amplification branch by the circulators. In other words, the technical solution provided in this application converts a wideband issue into a narrowband issue, and some amplification branches in the radio frequency power amplifier can be implemented by PAs with narrow bandwidths, so that PA efficiency is improved; and the wideband amplification branch provides a power sharing function, and a narrowband circulator together with the inter-frequency power division circuit performs power combination based on each frequency band to output a plurality of paths of narrowband signals, and therefore, the entire radio frequency power amplifier can process a high-power wideband signal. In addition, a narrowband isolator may be used at a lower level of each circulator, so that an isolator with a wide bandwidth is not required, and design difficulty of the isolator is reduced.

### BRIEF DESCRIPTION OF DRAWINGS

FIG. 1 is a diagram of an RRU;
FIG. 2 is a diagram of a radio frequency power amplifier according to an embodiment of this application;
FIG. 3 is a diagram of another radio frequency power amplifier according to an embodiment of this application;
FIG. 4 is a diagram of still another radio frequency power amplifier according to an embodiment of this application;
FIG. 5 is a diagram of still another radio frequency power amplifier according to an embodiment of this application;
FIG. 6 is a diagram of still another radio frequency power amplifier according to an embodiment of this application;
FIG. 7 is a diagram of still another radio frequency power amplifier according to an embodiment of this application;
FIG. 8 is a diagram of a current corresponding to FIG. 7 according to an embodiment of this application;
FIG. 9 is a diagram of a voltage corresponding to FIG. 7 according to an embodiment of this application;
FIG. 10 is a diagram of impedance corresponding to FIG. 7 according to an embodiment of this application;
FIG. 11 is a curve diagram of efficiency corresponding to FIG. 7 according to an embodiment of this application;
FIG. 12 is a diagram of still another radio frequency power amplifier according to an embodiment of this application;
FIG. 13 is a diagram of a current corresponding to FIG. 12 according to an embodiment of this application;
FIG. 14 is a diagram of a voltage corresponding to FIG. 12 according to an embodiment of this application;
FIG. 15 is a diagram of impedance corresponding to FIG. 12 according to an embodiment of this application;
FIG. 16 is a curve diagram of efficiency corresponding to FIG. 12 according to an embodiment of this application;
FIG. 17 is a diagram of still another radio frequency power amplifier according to an embodiment of this application;
FIG. 18 is a diagram of efficiency corresponding to FIG. 17 according to an embodiment of this application;
FIG. 19 is a diagram of a radio frequency power amplifier according to an embodiment of this application;
FIG. 20 is a diagram of another radio frequency power amplifier according to an embodiment of this application;
FIG. 21 is a diagram of a single-input multi-output radio frequency power amplifier according to an embodiment of this application;
FIG. 22 is a diagram of a single-input single-output radio frequency power amplifier according to an embodiment of this application;
FIG. 23 is a diagram of still another radio frequency power amplifier according to an embodiment of this application;
FIG. 24 is a diagram of still another radio frequency power amplifier according to an embodiment of this application; and
FIG. 25 is a diagram of a base station according to an embodiment of this application.

### DESCRIPTION OF EMBODIMENTS

The following describes the technical solutions in embodiments of this application with reference to the accompanying drawings in embodiments of this application.

The following terms "first", "second", and the like are only intended for a purpose of description, and shall not be understood as an indication or implication of relative importance or implicit indication of a quantity of indicated technical features. Therefore, a feature limited by "first", "second", or the like, may explicitly or implicitly include one or more features. In the descriptions of this application, unless otherwise stated, "a plurality of" means two or more than two.

In this application, unless otherwise specified and limited, the term "connection" should be understood in a broad sense. For example, the "connection" may be a fixed connection, a detachable connection, an integration, a direct connection, or an indirect connection by using an intermediate medium.

To enable a person skilled in the art to better understand technical solutions provided in embodiments of this application, the following first describes an application scenario of the technical solutions with reference to the accompanying drawings.

A radio frequency power amplifier provided in embodiments of this application is described by using an example in which the radio frequency power amplifier is applied to a remote radio unit (RRU, Radio Remote Unit) in a base station is used as an example. It should be noted that the radio frequency power amplifier in embodiments of this application is not limited to being applied to the RRU.

Main functions of the RRU include intermediate frequency processing, radio frequency processing, duplexing of signals, and the like. The radio frequency power amplifier is an important part of the RRU. Radio frequency signals are amplified by the radio frequency power amplifier and then transmitted through an antenna. Embodiments of this application specifically relates to a radio frequency power amplifier inside an RRU. For ease of description, the radio frequency power amplifier is referred to as a radio frequency power amplifier for short below.

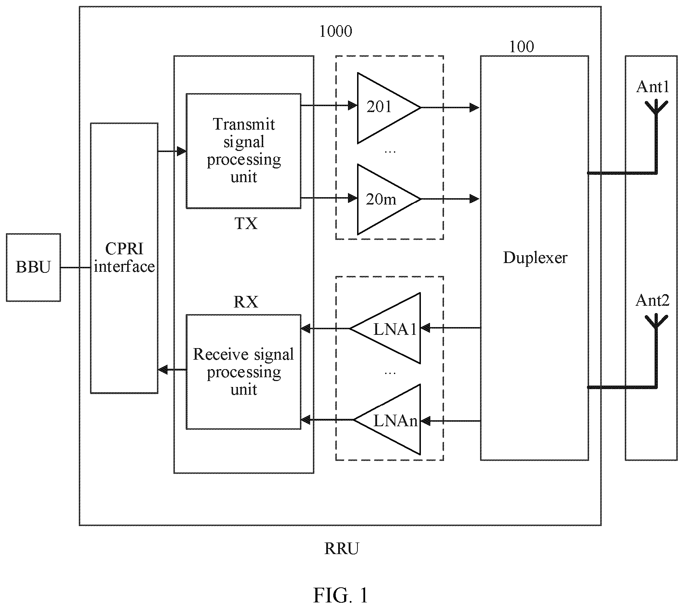

FIG. 1 is a diagram of an RRU.

An RRU 1000 provided in this embodiment of this application may be applied to a wireless communication base station. In addition to the RRU 1000, the base station may further include other components, for example, may further include an antenna feeder system and a baseband unit (BBU, Baseband Unit). The antenna feeder system may include a plurality of antennas. The following uses two antennas as an example, to be specific, a first antenna Ant1 and a second antenna Ant2 are configured to transmit a signal or receive a signal.

The RRU 1000 includes a radio frequency power amplifier, a low noise amplifier (LNA, Low Noise Amplifier), a duplexer 100, a transmit signal processing unit TX, a receive signal processing unit RX, and a common public radio interface (CPRI, Common Public Radio Interface).

The duplexer 100 is connected to the antenna feeder system, and the CPRI interface is connected to the BBU.

A quantity of radio frequency power amplifiers may be multiple based on a quantity of transmission paths, that is, may include a radio frequency power amplifier 201 to a radio frequency power amplifier 20m. Similarly, a quantity of LNAs may be multiple based on a quantity of receive channels, that is, may include an LNA1 to an LNAn.

In a signal transmission direction of the RRU 1000, a radio frequency signal of the transmit signal processing unit TX is amplified by the radio frequency power amplifier and then transmitted to the antenna feeder system through the duplexer 100.

In a signal receiving direction of the RRU 1000, radio frequency signals received by the antennas in the antenna feeder system are transmitted to the LNA through the duplexer 100, and signals obtained through amplification by the LNA are transmitted to the receive signal processing unit RX for processing.

In actual operation, an isolator needs to be connected at a lower level of the radio frequency power amplifier to. When a working frequency is wide, the radio frequency power amplifier and the isolator connected at the lower level need to support a corresponding working bandwidth. However, a design of a wideband isolator is difficult, especially in an ultra-wideband scenario. In addition, a design of a wideband radio frequency power amplifier is also difficult and usually has technical problems of poor performance such as low efficiency.

To resolve the foregoing problem that it is difficult to design the wideband isolator and the wideband radio frequency power amplifier, the technical solution provided in this application converts a wideband issue into a narrowband issue. Some amplification branches inside the radio frequency power amplifier are designed for narrowband, to improve efficiency of the PA. Some amplification branches inside the radio frequency power amplifier are designed for wideband, to provide a power sharing function. In addition, a narrowband circulator together with an inter-frequency power division circuit performs power combination on a signal output by a wideband amplification branch and a signal output by a narrowband amplification branch, and performs output based on each frequency band. A narrowband isolator may be used at a lower level of each circulator, so that an isolator with a wide bandwidth is not required, and design difficulty of the isolator is reduced.

To enable a person skilled in the art to better understand the technical solution provided in embodiments of this application, the following provides specific descriptions with reference to the accompanying drawings.

The radio frequency power amplifier provided in embodiments of this application does not specifically limit a quantity of input signal paths, for example, the quantity may be N, where N is an integer greater than or equal to 3. The radio frequency power amplifier may include N amplification branches, N-1 circulators, and at least one inter-frequency power division circuit.

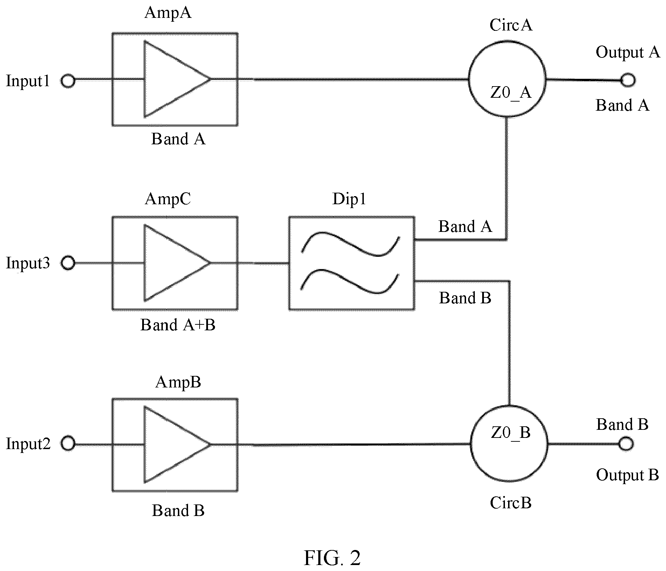

In addition, the radio frequency power amplifier provided in embodiments of this application may alternatively work in a scenario with only one path of input signal, or may work in a scenario with only two paths of input signals. For ease of understanding of the technical solution provided in embodiments of this application, the following first uses an example in which three paths of input signals are included for description. FIG. 2 is a diagram of a radio frequency power amplifier according to an embodiment of this application.

The radio frequency power amplifier provided in this embodiment includes: a first amplification branch AmpA, a second amplification branch AmpB, a third amplification branch AmpC, a first circulator CircA, a second circulator CircB, and a first inter-frequency power division circuit Dipl.

An input end of the first amplification branch AmpA is configured to connect to a first path of signal Input1, an input end of the second amplification branch AmpB is configured to connect to a second path of signal Input2, and an input end of the third amplification branch AmpC is configured to connect to a third path of signal Input3.

An output end of the third amplification branch AmpC is connected to an input end of the first inter-frequency power division circuit Dipl.

A working frequency band of the first amplification branch AmpA is a frequency band A Band A, a working frequency band of the second amplification branch AmpB is a frequency band B Band B, and a working frequency band of the third amplification branch AmpC is the frequency band A and the frequency band B (Band A+B), that is, the working frequency band of the third amplification branch AmpC covers both the frequency band A and the frequency band B. A working frequency band of the first circulator is the frequency band A Band A, and a working frequency band of the second circulator is a frequency band B Band B. The first inter-frequency power division circuit Dipl is configured to: perform inter-frequency power division on an output signal of the third amplification branch AmpC, and respectively output a frequency band A signal and a frequency band B signal, which respectively correspond to a Band A signal and a Band B signal.

An output end of the first amplification branch AmpA and a first output end of the first inter-frequency power division circuit Dipl are respectively connected to different ports of the first circulator CircA. The first circulator CircA is configured to perform power combination on a frequency band A signal output by the first amplification branch AmpA and the frequency band A signal output by the first inter-frequency power division circuit Dipl, and then perform output, that is, an output end Output A outputs a Band A signal.

An output end of the second amplification branch AmpB and a second output end of the first inter-frequency power division circuit Dipl are respectively connected to different ports of the second circulator CircB. The second circulator CircB is configured to: perform power combination on a frequency band B signal output by the second amplification branch AmpB and the frequency band B signal output by the first inter-frequency power division circuit Dipl, and then perform output, that is, an output end Output B outputs a Band B signal.

The first circulator CircA and an isolator at a lower level may be designed as one device to reduce an area and a cascading insertion loss. Similarly, the second circulator CircB and an isolator at a lower level may be designed as one device to reduce an area and a cascading insertion loss.

In general, characteristic impedance Z0_A of the first circulator CircA and characteristic impedance Z0_B of the second circulator CircB are both 50 ohms (Ohm).

A port type of a circulator connected to the first inter-frequency power division circuit Dipl is not specifically limited in this embodiment of this application. Herein, the port type of the circulator indicates an isolation port or an input port. For example, the first inter-frequency power division circuit Dipl may be connected to the isolation port of the circulator, or may be connected to the input port of the circulator.

It can be learned from FIG. 2 that, based on the radio frequency power amplifier provided in this embodiment of this application, three paths of signals are input and two paths of signals are output, a bandwidth on which input signals can be processed is the frequency band A+B, and bandwidths of the two paths of output signals are the frequency band A and the frequency band B respectively. In this way, an isolator whose working frequency band is the frequency band A can be connected at the lower level of the first circulator, and an isolator whose working frequency band is the frequency band B can be connected at the lower level of the second circulator. In other words, in this application, that the input signals are on the frequency band A+B does not mean that an isolator of the frequency band A+B needs to be used at a lower level, but an isolator of a narrow frequency band may be used instead, to reduce design difficulty of the isolator.

Both the first amplification branch AmpA and the second amplification branch AmpB may be designed as narrowband PAs, and design difficulty thereof is reduced, thereby achieving higher efficiency easily. The third amplification branch AmpC designed as a wideband PA provides a power sharing function.

It should be understood that the frequency band A and the frequency band B described in the foregoing embodiments of this application may be a single frequency band, or may be a plurality of frequency bands. For example, the frequency band A may be a frequency band A1 + a frequency band A2, or the frequency band A may be a frequency band A1 + a frequency band A2 + a frequency band A3. Similarly, the frequency band B may be a frequency band B1 + a frequency band B2, or the frequency band B may be a frequency band B1 + a frequency band B2 + a frequency band B3.

The frequency band A and the frequency band B are different frequency bands. In other words, the frequency band A and the frequency band B do not have an overlapping frequency band range, that is, the two frequency bands do not have an overlapping frequency. A frequency of the frequency band A may be greater than that of the frequency band B, or a frequency of the frequency band A may be less than that of the frequency band B. This is not specifically limited in this embodiment of this application. For ease of description, the following describes a working principle of the radio frequency power amplifier provided in this embodiment of this application through an example in which the frequency of the frequency band A is less than that of the frequency band B.

When the radio frequency power amplifier works only in the frequency band A, no signal is input to the AmpB, and the AmpB is in a closed status. In this case, only the AmpA and the AmpC work, and both the AmpA and the AmpC work on the frequency band A. Both the Input1 and the Input3 input frequency band A signals, and the Output A outputs frequency band A signals.

When the radio frequency power amplifier works only in the frequency band B, no signal is input to the AmpA, and the AmpA is in a closed status. In this case, only the AmpB and the AmpC work, and both work on the frequency band B. Both the Input2 and the Input3 input frequency band B signals, and the Output B outputs frequency band B signals.

When the radio frequency power amplifier works on both the frequency band A and the frequency band B, the AmpA, the AmpB, and the AmpC all work. The AmpA works in the frequency band A, the AmpB works in the frequency band B, and the AmpC works in the frequency band A+B. The Input1 inputs the frequency band A signal, the Input2 inputs the frequency band B signal, and the Input3 inputs the frequency band A+B signal. The Output A outputs the frequency band A signal, and the Output B outputs the frequency band B signal.

In addition, to achieve better performance of the radio frequency power amplifier, Z0_A and/or Z0_B may be optimized. For example, low impedance design is performed on a high-power radio frequency power amplifier. In this case, an impedance transforming network needs to be arranged only on two circulator output ports, for example, transforming from Z0_A to 50 ohms, and transforming from Z0_B to 50 ohms.

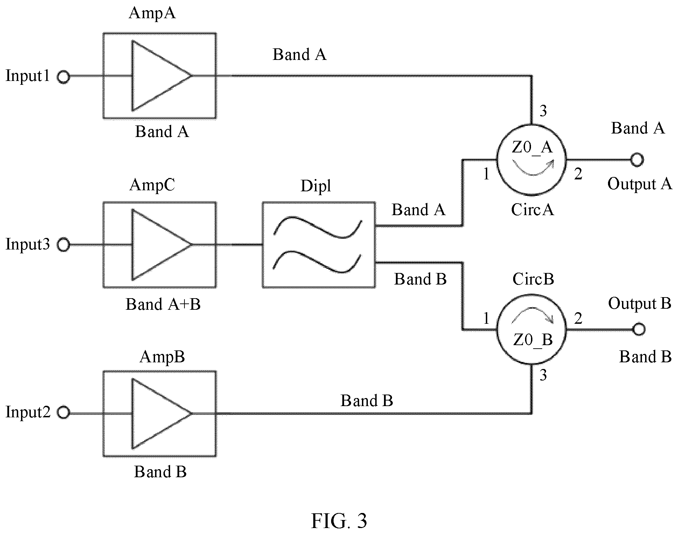

A specific port of the circulator connected to the first inter-frequency power division circuit is not limited in FIG. 2. Based on the embodiment in FIG. 2, a specific implementation is described with reference to FIG. 3. In FIG. 3, an example in which the input port of the circulator is connected to the first inter-frequency power division circuit is used for description.

FIG. 3 is a diagram of another radio frequency power amplifier according to an embodiment of this application.

In this embodiment, the first output end of the first inter-frequency power division circuit Dipl is connected to an input port of the first circulator CircA, and the first amplification branch AmpA is connected to an isolation port of the first circulator CircA.

Similarly, the second output end of the first inter-frequency power division circuit Dipl is connected to an input port of the second circulator CircB, and the second amplification branch AmpB is connected to an isolation port of the second circulator CircB.

As the AmpA and the AmpB are connected to isolation ports of the circulators, output loads of the AmpA and the AmpB remain unchanged, facilitating an independent design, and a working bandwidth may be relatively wide.

In FIG. 3, an example in which the first amplification branch and the second amplification branch are connected to the isolation ports of the circulators is used for description. The following describes another implementation in which the output end of the first inter-frequency power division circuit is connected to the isolation ports of the circulators.

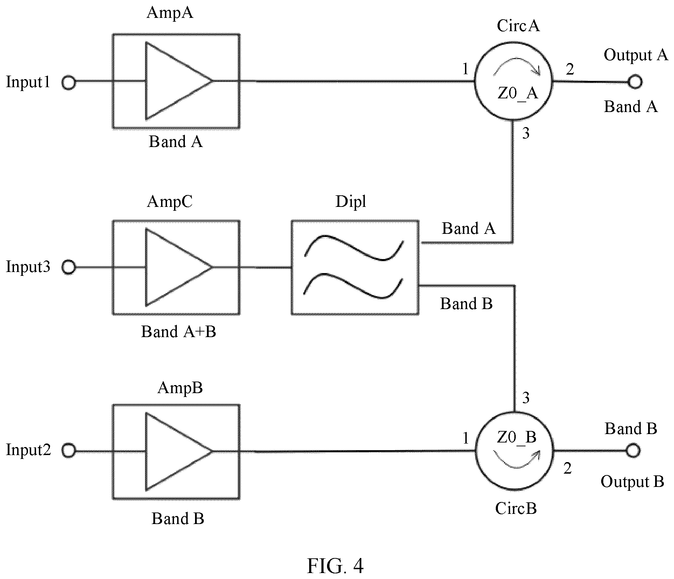

FIG. 4 is a diagram of still another radio frequency power amplifier according to an embodiment of this application.

In this embodiment, the first output end of the first inter-frequency power division circuit Dipl is connected to the isolation port of the first circulator CircA, and the first amplification branch AmpA is connected to the input port of the first circulator CircA.

Similarly, the second output end of the first inter-frequency power division circuit Dipl is connected to the isolation port of the second circulator CircB, and the second amplification branch AmpB is connected to the input port of the second circulator CircB.

As the first inter-frequency power division circuit is connected to the isolation ports of the circulators, an output load of the first inter-frequency power division circuit remains unchanged, facilitating an independent design of the third amplification branch AmpC and the first inter-frequency power division circuit. In addition, if the AmpA and the AmpB work first, an insertion loss is relatively small at a low power, and efficiency in a low-power region is relatively high.

Port types of the circulators connected to the first amplification branch and the second amplification branch in FIG. 3 and FIG. 4 are the same. It should be understood that the port types of the circulators connected to the first amplification branch and the second amplification branch may alternatively be different. For example, the first amplification branch is connected to the isolation port of the first circulator, and the second amplification branch is connected to the input port of the second circulator. The following provides descriptions in detail with reference to the accompanying drawings.

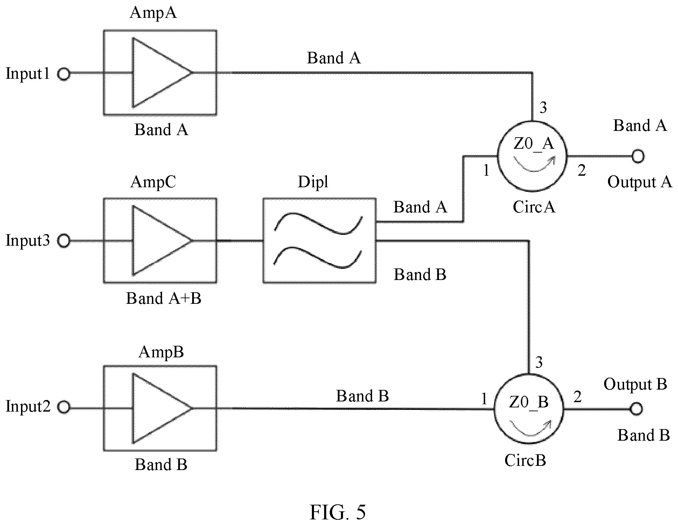

FIG. 5 is a diagram of still another radio frequency power amplifier according to an embodiment of this application.

In this embodiment, the first output end of the first inter-frequency power division circuit Dipl is connected to an input port of the first circulator CircA, and the first amplification branch AmpA is connected to an isolation port of the first circulator CircA.

The second output end of the first inter-frequency power division circuit Dipl is connected to the isolation port of the second circulator CircB, and the second amplification branch AmpB is connected to the input port of the second circulator CircB.

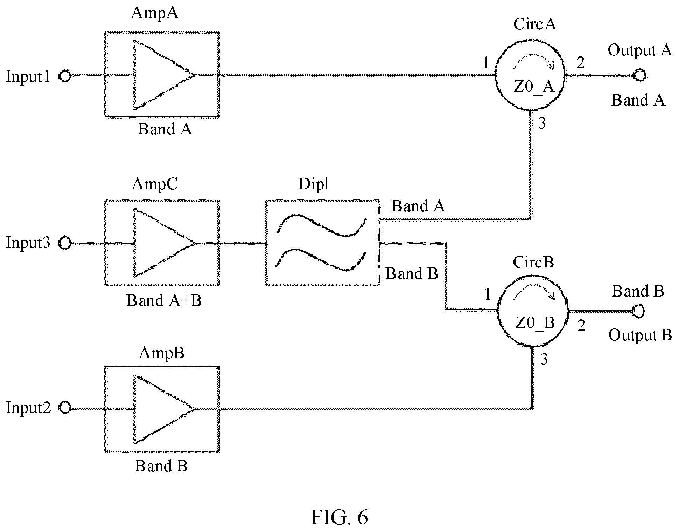

FIG. 6 is a diagram of still another radio frequency power amplifier according to an embodiment of this application.

In this embodiment, the first output end of the first inter-frequency power division circuit Dipl is connected to the isolation port of the first circulator CircA, and the first amplification branch AmpA is connected to the input port of the first circulator CircA.

The second output end of the first inter-frequency power division circuit Dipl is connected to the input port of the second circulator CircB, and the second amplification branch AmpB is connected to the isolation port of the second circulator CircB.

A specific type of a PA included in each amplification branch is not specifically limited in this embodiment of this application. The first amplification branch, the second amplification branch, and the third amplification branch each are any one of the following types, but are not limited to the following types:
a single-transistor PA, a Doherty PA, a Chireix PA, a timing Doherty PA, a load modulated balance amplifier (LMBA, Load Modulated Balanced Amplifier), or a circulator load modulated amplifier (CLMA, Circulator Load Modulated Amplifier).

The following first describes an implementation in which all three amplification branches are single-transistor PAs with reference to the accompanying drawings.

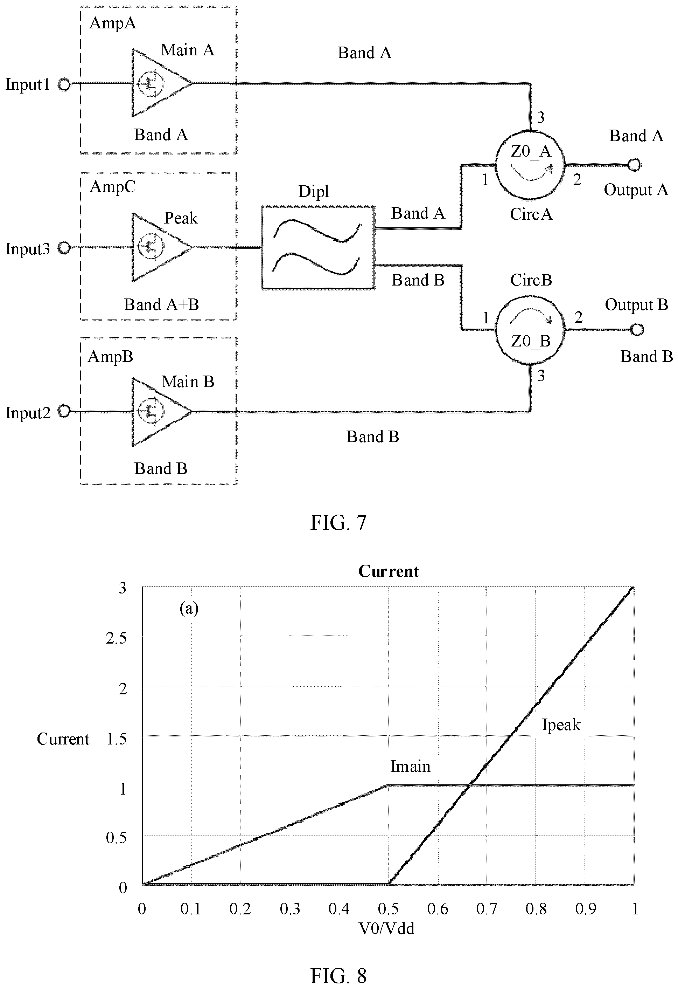

FIG. 7 is a diagram of still another radio frequency power amplifier according to an embodiment.

The first amplification branch AmpA includes the single-transistor PA, and the single-transistor PA of the first amplification branch AmpA is referred to as a first carrier PA, and is represented by Main A.

The second amplification branch AmpB includes the single-transistor PA, and the single-transistor PA of the second amplification branch AmpB is referred to as a second carrier PA, and is represented by Main B.

The third amplification branch AmpC includes the single-transistor PA, and the single-transistor PA of the third amplification branch AmpC is referred to as a peak PA, and is represented by Peak.

The AmpA and the AmpB work before the AmpC.

The Main A works on the Band A, the Main B PA unit works on the Band B, and the Peak works on the Band A+B. The Peak provides the power sharing function.

When the radio frequency power amplifier works only on the Band A, the Main B is in a closed status, no signal is input to the Main B, and the Main B is biased in a Class C. In this case, only the Main A and the Peak work, the Main A works in a Class AB or a Class B, and the Peak works in the Class C. A working mechanism of the Main A and the Peak is an SCLMA working mode.

When power of an input signal of the radio frequency power amplifier is low, only the Main A works until the power is saturated. Then the Peak is turned on, and the Main A remains in a saturation state, until both the Main A and the Peak reach saturation.

When the radio frequency power amplifier works only on the Band B, the Main A is in a closed status, no signal is input to the Main A, and the Main A is biased in the Class C. In this case, the Main B and the Peak work, the Main B works in the Class AB or the Class B, and the Peak works in the Class C. In this case, a working mechanism of the Main B and the Peak is similar to those described above.

When the radio frequency power amplifier works on both the Band A and the Band B, curve diagrams of a current, a voltage, impedance, and efficiency of the radio frequency power amplifier are shown in FIG. 8 to FIG. 11. Main in each curve diagram refers to the Main A or the Main B. FIG. 8 to FIG. 11 all correspond to a scenario in which a saturation-power ratio of the Main to the Peak equal to 1:3.

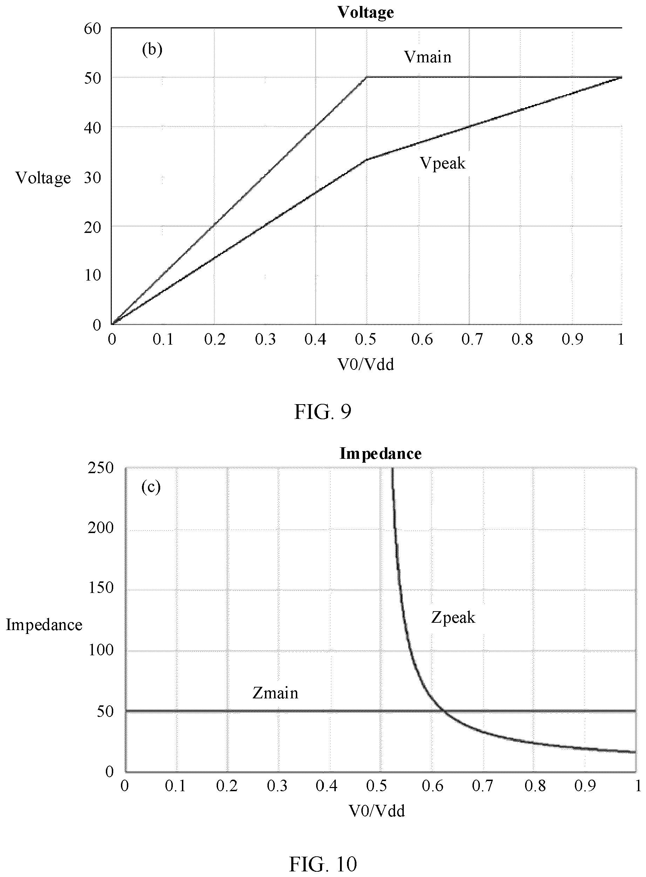

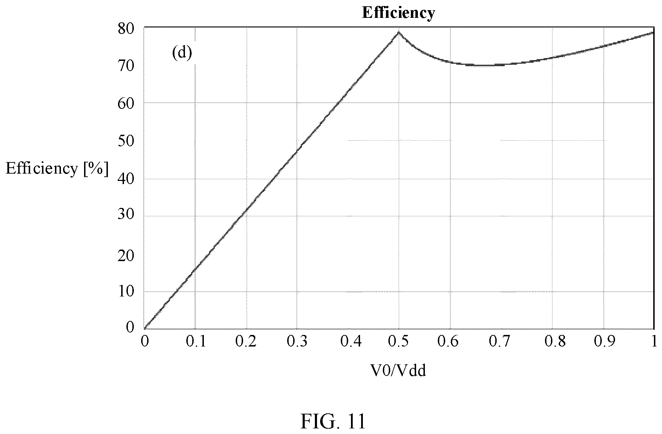

An abscissa in FIG. 8 to FIG. 11 is a normalized voltage (V0/Vdd), and a normalization manner is a ratio of an output voltage V0 of a PA to a drain bias voltage Vdd. An ordinate in FIG. 8 represents an output current (Current), an ordinate in FIG. 9 represents a voltage (Voltage), and an ordinate in FIG. 10 represents impedance (Impedance). An ordinate in FIG. 11 represents efficiency (Efficiency).

In FIG. 8, Imain is an output current of the Main, and Ipeak is an output current of the Peak. It can be seen from the current diagram shown in FIG. 8 that the Imain reaches current saturation earlier than the Ipeak.

In FIG. 9, Vmain is an output voltage of the Main, and Vpeak is an output voltage of the Peak. It can be seen from the voltage diagram shown in FIG. 9 that the Vmain reaches voltage saturation earlier than the Vpeak.

It can be seen from the impedance curve shown in FIG. 10 that a load-pull ratio of the Main is 1, that is, a load Zmain of the Main remains unchanged.

In the curve diagram of efficiency in FIG. 11, the Main reaches saturation at a first high efficiency point, and both the Main and the Peak reach saturation at the second high efficiency point.

When the radio frequency power amplifier works on both the Band A and the Band B, the Main A, the Main B, and the Peak all work. In this case, both the Main A and the Main B work in the Class AB or the Class B, the Peak works in the Class C, the Main A works on the Band A, the Main B works on the Band B, and the Peak works on both the Band A and the Band B. After passing through the first inter-frequency power division circuit Dipl, a Peak output forms the SCLMA working mode with the Main A and the Main B separately.

PAs in the three amplification branches in the radio frequency power amplifier described in FIG. 7 are all implemented by the single-transistor PA. The following describes another implementation.

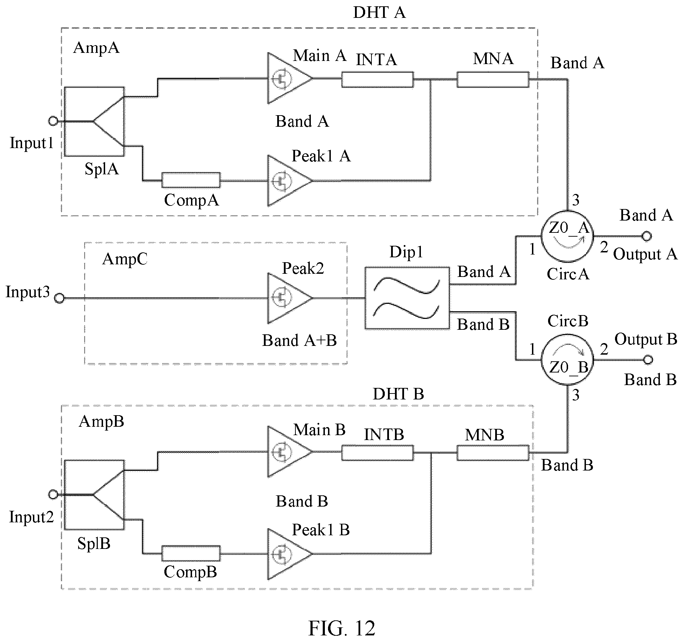

FIG. 12 is a diagram of still another radio frequency power amplifier according to an embodiment of this application.

In the radio frequency power amplifier provided in this embodiment, the first amplification branch and the second amplification branch are Doherty PAs, and the third amplification branch is the single-transistor PA.

The third amplification branch is referred to as a peak PA, and is represented by Peak2.

The single-transistor PAs in FIG. 7 are all replaced by the Doherty (DHT for short) PAs, and other structures remain unchanged, which are not described herein again.

The PA AmpA in the first amplification branch in FIG. 12 is used as an example for description. The DHT PA includes: a first power splitter SplA, a carrier PA Main A, and a peak PA Peak1 A, and further includes a phase compensation network CompA, an impedance inverting network INTA, and a matching network MNA.

The first path of signal Input 1 is input to an input port of the first power splitter SplA, and after being power-split by the first power splitter SplA, the first path of signal is input to the Main A and the Peak1 A, where a signal output by the Main A is combined with a signal output by the Peak1 A after being processed by the INTA, and then is input to an isolation port 3 of the first circulator CircA through the MNA.

In FIG. 12, an architecture of the DHT PA in the second amplification branch is the same as an architecture of the DHT PA in the first amplification branch, and a path of the second path input signal Input2 in FIG. 12 is the same as a path of the Input1. Details are not described herein again.

When the AmpA and the AmpB are implemented through the Doherty PA architecture, the AmpC is implemented through the single-transistor PA, and the AmpA and the AmpB work before the AmpC, the Input1 is divided into two paths after being power-split by the SplA. One path is connected to the Main A, and another path is connected to the Peak1 A through the CompA. The Main A and the Peak1 A are combined by the INTA and the MNA to form a DHT A, which is connected to the isolation port 3 of the circulator CirA. The DHT A works on the Band A.

The Input2 is divided into two paths after being power-split by an SplB. One path is connected to the Main B, and another path is connected to a Peak1 B through a CompB. The Main B and the Peak1 B are combined by an INTB and an MNB to form a DHT B, which is connected to an isolation port 3 of the circulator CircB. The DHT B works on the Band B.

The Input3 is connected to an input end of the Peak2. The Peak2 works on the Band A and the Band B and provides the power sharing function. After being power-split by the Dipl, two output paths of the Dipl respectively output the Band A signal and the Band B signal, which are connected to an input port 1 of the CircA and an input port 1 of the CircB. A port 2 of the CircA is the output port, and a port 2 of the CircB is the output port, which respectively output a Band A signal and a Band B signal.

When the radio frequency power amplifier works only on the Band A, the Main B and the Peak1 B are closed, no signal is input to the Input2, and the Main B and the Peak1 B are biased in the Class C. In this case, only the Main A, the Peak1 A, and the Peak2 work. The Main A is biased in the Class AB or the Class B, the Peak1 A is biased in a shallow Class C, and the Peak2 is biased in a deep Class C.

When power of an input signal is low, only the Main A works until a voltage of the Main A is saturated. Then, the Peak1 A starts to work, and load modulation is performed on the Main A. The Main A maintains voltage saturation unchanged until the Peak1 A also reaches saturation. In this case, the Main A and the Peak1 A reach current saturation. The foregoing is a DHT pull mechanism. Then, the Peak2 starts to work, and the Main A and the Peak1 A maintains saturation unchanged until the Peak2 reaches saturation. In this case, the SCLMA working mode is enabled.

When the radio frequency power amplifier works only on the Band B, the Main A and the Peak1 A are closed, no signal is input to the Input1, and the Main A and the Peak1 A are biased in the Class C. In this case, only the Main B, the Peak1 B, and the Peak2 work. A working mechanism is consistent with that when the radio frequency power amplifier works only on the Band A.

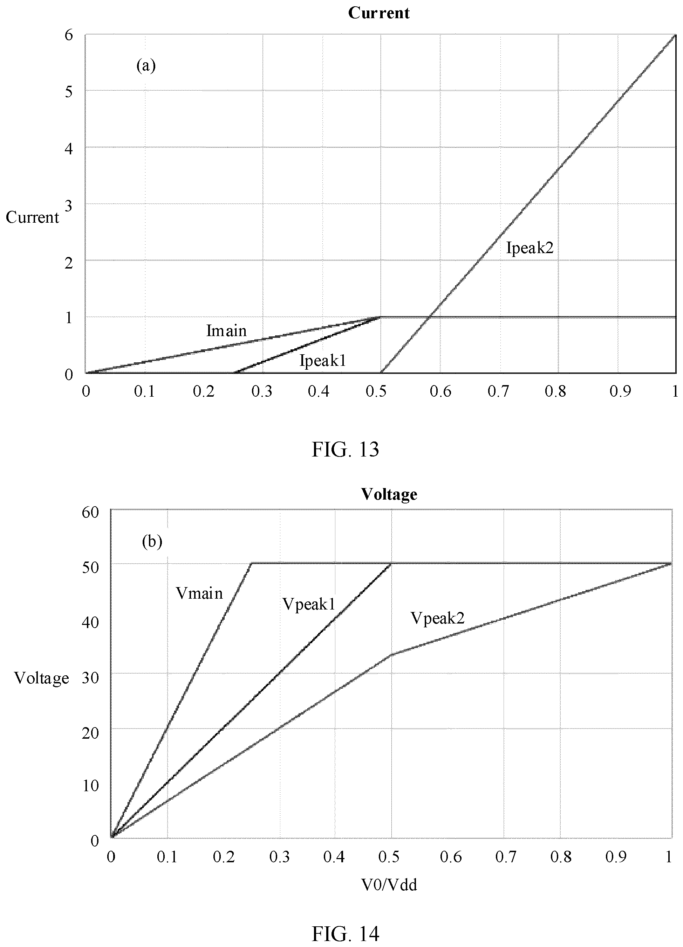

FIG. 13 is a diagram of a current corresponding to a scenario in which the radio frequency power amplifier in FIG. 12 works only on the Band A or the Band B according to an embodiment of this application.

FIG. 14 is a diagram of a voltage corresponding to a scenario in which the radio frequency power amplifier in FIG. 12 works only on the Band A or the Band B according to an embodiment of this application.

An abscissa in FIG. 13 and FIG. 14 is a normalized voltage (V0/Vdd). An ordinate in FIG. 13 represents a current (Current), and an ordinate in FIG. 14 represents a voltage (Voltage).

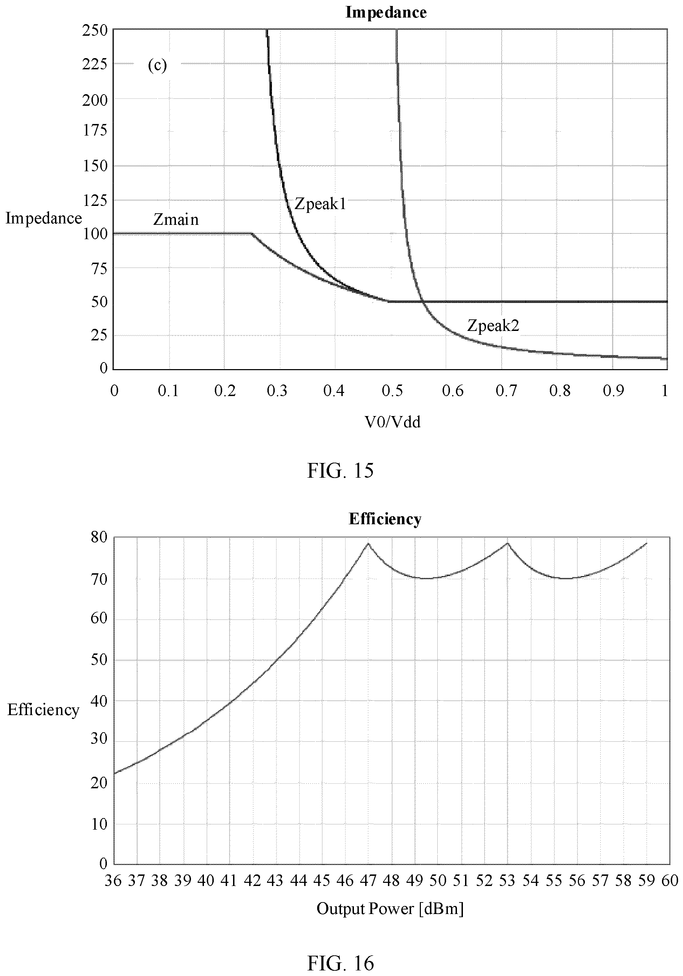

FIG. 15 is a diagram of impedance corresponding to a scenario in which the radio frequency power amplifier in FIG. 12 works only on the Band A or the Band B according to an embodiment of this application.

FIG. 16 is a curve diagram of efficiency in a scenario in which the radio frequency power amplifier in FIG. 12 works only on the Band A or the Band B according to an embodiment of this application.

An abscissa in FIG. 15 is a normalized voltage (V0/Vdd), and an ordinate in FIG. 15 represents impedance (Impedance).

An abscissa in FIG. 16 is output power Output Power, and an ordinate in FIG. 16 represents efficiency (Efficiency).

In each curve diagram in FIG. 13 to FIG. 16, Main refers to the Main A or the Main B, Peak1 refers to the Peak1 A or the Peak1 B. Each curve diagram is a curve diagram when a saturation-power ratio is Main:Peak1:Peak2=1:1:6.

It can be seen from FIG. 13 that Imain reaches current saturation earlier than Ipeak1, and the Ipeak1 reaches current saturation earlier than Ipeak2.

It can be seen from FIG. 14 that, the Main first reaches voltage saturation, then the Peak1 reaches voltage saturation, and finally the Peak2 reaches voltage saturation, in other words, Vmain reaches voltage saturation earlier than Vpeak1, the Vpeak1 reaches voltage saturation earlier than Vpeak2, and finally the Vpeak2 reaches voltage saturation.

FIG. 16 is a curve diagram of efficiency in a scenario in which the saturation-power ratio is Main:Peak1:Peak2=100 W:100 W:600 W. It can be seen from the curve diagram of efficiency in FIG. 16 that there are three high-efficiency points, so that sizes of lower areas can be reduced.

It can be seen from FIG. 16 that the radio frequency power amplifier can implement a 12 dB back-off design.

When the radio frequency power amplifier works on both the Band A and the Band B, the DHT A, the DHT B, and the Peak2 all work. In the DHT A, the Main A is biased in the Class AB or the Class B, and the Peak1 A is biased in the shallow Class C. In the DHT B, the Main B is biased in the Class AB or the Class B, the Peak1 B is biased in the shallow Class C, and the Peak2 is biased in the deep Class C. The DHT A works on the Band A, the DHT B works on the Band B, and the Peak2 works on both the Band A and the Band B. After passing through the first inter-frequency power division circuit Dipl, an output of the Peak2 separately forms the SCLMA working mode with the DHT A and the DHT B.

In the foregoing descriptions of FIG. 12, an example is used in which output ends of the first inter-frequency power division circuit are connected to input ports of the circulators. In the following descriptions, another example is used in which the output ends of the first inter-frequency power division circuit are connected to isolation ports of the circulators, and PAs in the first amplification branch, the second amplification branch, and the third amplification branch are all Doherty PAs.

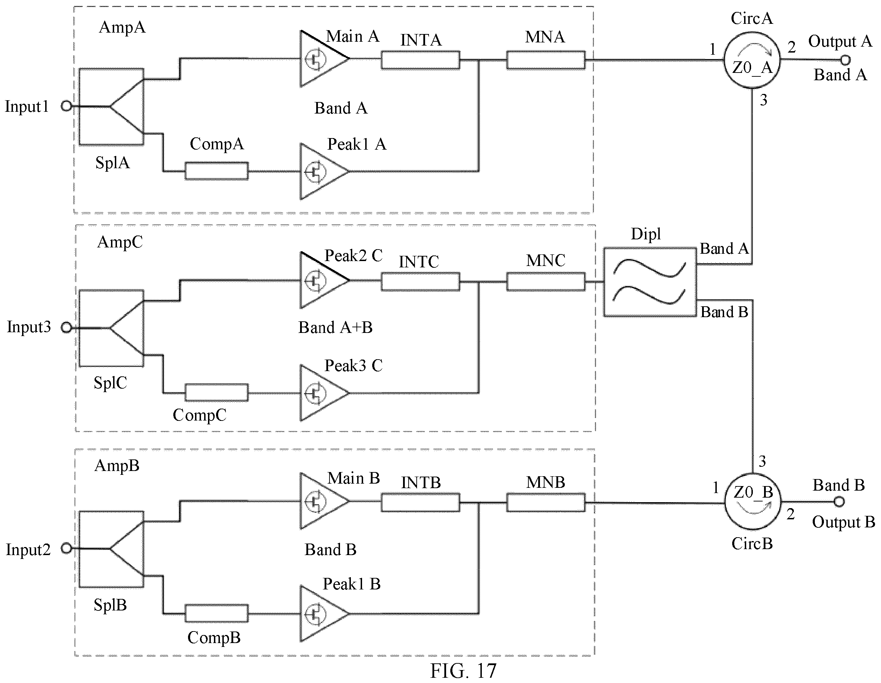

FIG. 17 is a diagram of still another radio frequency power amplifier according to an embodiment of this application.

In the radio frequency power amplifier provided in this embodiment, the first amplification branch, the second amplification branch, and the third amplification branch are Doherty PAs.

When the AmpA, the AmpB, and the AmpC are all implemented by the DHT PAs, and the AmpA and the AmpB work before the AmpC, the Input1 is divided into two paths after being power-split by the SplA. One path is connected to the Main A, and another path is connected to the Peak1 A through the phase compensation network CompA. An output of the Main A passes through the INTA and is combined with an output of the Peak1 APA, and then a combined output passes through the impedance transforming network MNA to connect to the input port 1 of the first circulator CircA.

The Input2 is divided into two paths after being power-split by the SplB. One path is connected to the Main B, and another path is connected to the Peak1 B through the phase compensation network CompB. An output of the Main B passes through the INTB and is combined with an output of the Peak1 B, and then a combined output passes through the impedance transforming network MNB to connect to the input port 1 of the second circulator CircB.

The Input3 is divided into two paths after being power-split by an Spl3. One path is connected to a Peak2 C, and another path is connected to a Peak3 C after passing through a phase compensation network CompC. An output of the Peak2 C passes through an INTC and is combined with an output of the Peak3 C, and then a combined output passes through an impedance transforming network MNC to connect to the first inter-frequency power division circuit Dipl. After passing through the first inter-frequency power division circuit Dipl, two paths are output, which respectively output a Band A signal and a Band B signal. The two paths output by the Dipl are respectively connected to the isolation port 3 of the CircA and the isolation port 3 of the CircB. The output port 2 of the CircA and the output port 2 of the CircB respectively output the Band A signal and the Band B signal.

When the radio frequency power amplifier works only on the Band A, the AmpB is in a closed status. In this case, the Main B and the Peak1 B in the AmpB are biased in the Class C. The AmpA and the AmpC work; the Main A is biased in the Class AB or the Class B; and the Peak1 A, the Peak2 C, and the Peak3 C are biased in the Class C.

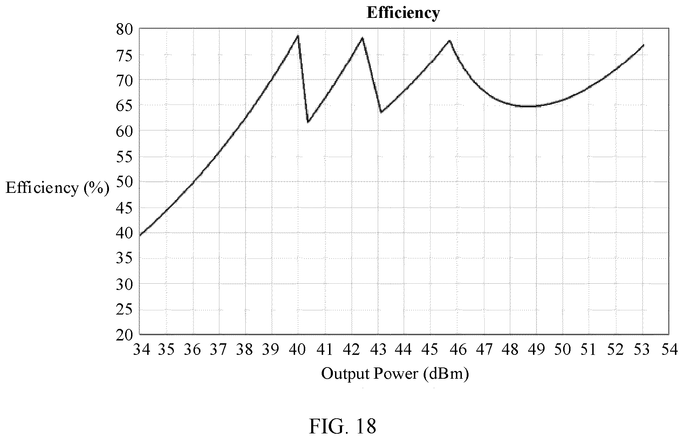

FIG. 18 is a curve diagram of efficiency when a saturation-power ratio of the Main A, the Peak1 A, the Peak2 C, and the Peak3 C is 10 W:40 W:53.3 W: 106.7 W. An abscissa in FIG. 18 is output power Output Power, and an ordinate in FIG. 18 represents the efficiency (Efficiency).

It can be seen from FIG. 18 that the radio frequency power amplifier can implement a power back-off of about 13 dB.

When the radio frequency power amplifier works only on the Band B, the AmpA is in a closed status. In this case, the Main A and the Peak1 A in the AmpA are biased in the Class C, and the AmpB and the AmpC work. In this case, the Main B is biased in the Class AB or the Class B, and the Peak1 B, the Peak2 C, and the Peak3 C are biased in the Class C. A working mechanism is the same as that foregoing above.

When the radio frequency power amplifier works on both the Band A and the Band B, the AmpA, the AmpB, and the AmpC all work. The Main A and the Main B are biased in the Class AB or the Class B, and others are biased in the Class C. The Input1 inputs a Band A signal, the Input2 inputs a Band B signal, and the Input3 inputs a Band A+B signal. The Output A outputs a Band A signal, and the Output B outputs a Band B signal.

The foregoing embodiments describe the radio frequency power amplifier with three paths of input signals. The following describes an implementation of the radio frequency power amplifier with more paths of input signals. A quantity of input signal paths is not specifically limited in this embodiment of this application. For ease of description, an example with four paths of input signals is used for description in the following.

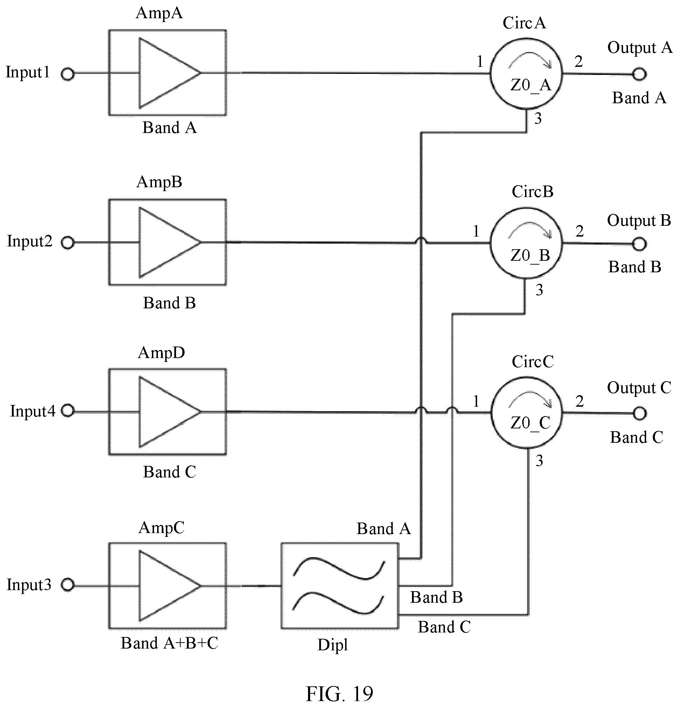

FIG. 19 is a diagram of a radio frequency power amplifier according to an embodiment of this application.

A difference between the radio frequency power amplifier provided in this embodiment and that in FIG. 3 is that the radio frequency power amplifier further includes a fourth amplification branch AmpD and a third circulator CircC.

The third amplification branch AmpC works on the frequency band A, the frequency band B, and a frequency band C. The frequency band C is different from either the frequency band A or the frequency band B. For example, in a possible implementation, a frequency of the frequency band A is less than a frequency of the frequency band B, and the frequency of the frequency band B is less than a frequency of the frequency band C.

An input end of the fourth amplification branch AmpD is configured to connect to a fourth path of signal Input4.

An output end of the fourth amplification branch AmpD and a third output end of the first inter-frequency power division circuit Dipl are respectively connected to different ports of the third circulator CircC. The first inter-frequency power division circuit Dipl is configured to: perform inter-frequency power division on a signal output by the third amplification branch AmpC, and then respectively output a frequency band A signal, a frequency band B signal, and a frequency band C signal, that is, a Band A signal, a Band B signal, and a Band C signal.

The third circulator CircC works on the frequency band C.

The third circulator CircC is configured to: perform power combination on a frequency band C signal output by the fourth amplification branch AmpD and the frequency band C signal output by the first inter-frequency power division circuit Dipl, and then perform output.

It can be learned by comparing FIG. 19 and FIG. 3 that the first inter-frequency power division circuit Dipl includes three output ends, which respectively output signals of three different frequency bands, and the third amplification branch AmpC may process signals of a wider frequency band.

The radio frequency power amplifier may input four paths of signals, and output three paths of signals of different frequency bands. Each output end may be connected to a corresponding isolator, so that the corresponding isolator only needs to ensure that a signal of a corresponding frequency band can be processed, and the isolator does not need to work on all working frequency bands. This can reduce design difficulty of the isolator, and can be implemented through an isolator with a narrow bandwidth.

A type of the PA in FIG. 19 is not specifically limited in this embodiment of this application. The PA may be the single-transistor PA, or may be the Doherty PA, the timing Doherty PA, the Chireix PA, the LMBA, the CLMA, or the like.

In FIG. 19, an output end of the first inter-frequency power division circuit Dipl is connected to an isolation port of the circulator, that is, the first output end of the first inter-frequency power division circuit Dipl is connected to the isolation port 3 of the first circulator CircA. The second output end of the first inter-frequency power division circuit Dipl is connected to the isolation port 3 of the second circulator CircB. The third output end CircA of the first inter-frequency power division circuit Dipl is connected to the isolation port 3 of the third circulator CircC. This facilitates an independent design of the first inter-frequency power division circuit Dipl and the third amplification branch AmpC.

With reference to the accompanying drawings, the following describes an implementation in which the output end of the first inter-frequency power division circuit Dipl is connected to the input port of the circulator.

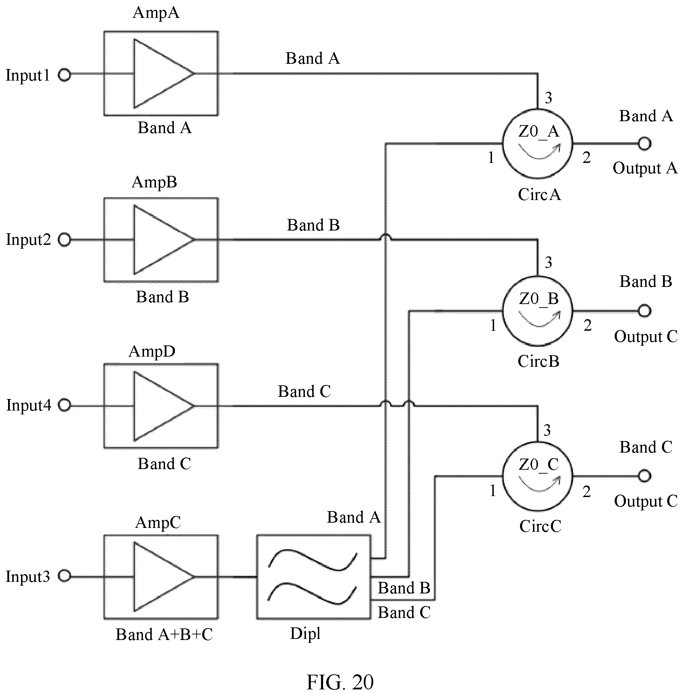

FIG. 20 is a diagram of another radio frequency power amplifier according to an embodiment of this application.

A difference between FIG. 20 and FIG. 19 is that in FIG. 20, the first output end of the first inter-frequency power division circuit Dipl is connected to the input port 1 of the first circulator CircA; the second output end CircA of the first inter-frequency power division circuit Dipl is connected to the input port 1 of the second circulator CircB; and the third output end CircA of the first inter-frequency power division circuit Dipl is connected to an input port 1 of the third circulator CircC.

A working principle of FIG. 19 and FIG. 20 is similar to that of three paths of input signals, and details are not described herein again.

All last-level power combination units of the radio frequency power amplifiers described in the foregoing embodiments of this application are the circulators. As the circulators are suitable for a high-power scenario, and can process a signal with high power, the radio frequency power amplifiers provided in embodiments of this application can be applied to an ultra-wideband scenario with high power.

In the foregoing embodiments, the radio frequency power amplifiers are described by using a plurality of paths of input signals and a plurality of paths of output signals as an example. The radio frequency power amplifier provided in embodiments of this application may also be applied to a scenario with a single path of an input signal. The following provides descriptions with reference to the accompanying drawings.

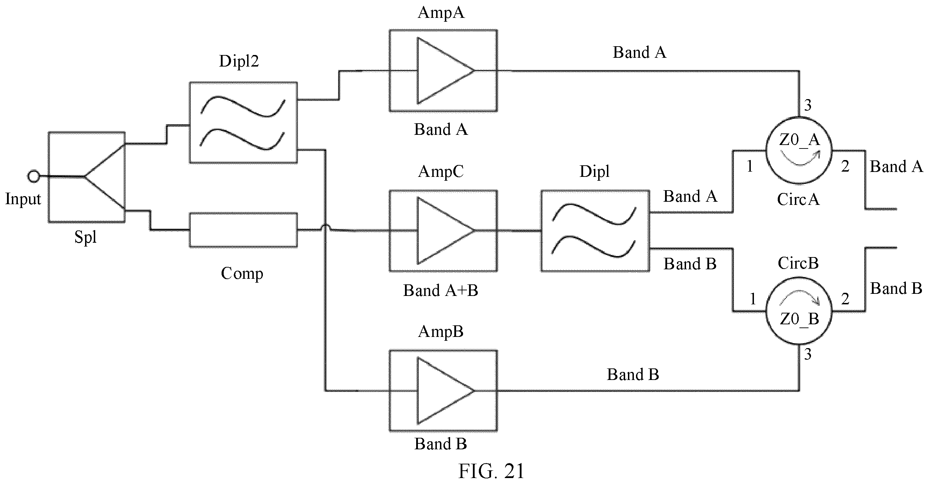

FIG. 21 is a diagram of a single-input multi-output radio frequency power amplifier according to an embodiment of this application.

The radio frequency power amplifier provided in this embodiment further includes: a second inter-frequency power division circuit Dipl2, a power splitter Spl, and a phase compensation network Comp.

A first output end of the power splitter Spl is connected to an input end of the second inter-frequency power division circuit Dipl2, and a first output end and a second output end of the second inter-frequency power division circuit Dipl2 are respectively connected to the first amplification branch AmpA and the second amplification branch AmpB. A second output end of the power splitter Spl is connected to a first end of the phase compensation network Comp, and a second end of the phase compensation network Comp is connected to the third amplification branch AmpC.

After an input signal Input is power-split by the power splitter Spl, one path passes through the second inter-frequency power division circuit Dipl2 and is respectively connected to input ports of the AmpA and the AmpB, and another path output by the power splitter Spl passes through the phase compensation network Comp and is connected to an input port of the AmpC. It can be learned that the radio frequency power amplifier can be applied to a scenario with only one path of an input signal.

The radio frequency power amplifiers described in the foregoing embodiments are all multi-output ones. The following describes a scenario in which the radio frequency power amplifier provided in embodiments of this application may alternatively be applied to a single-output.

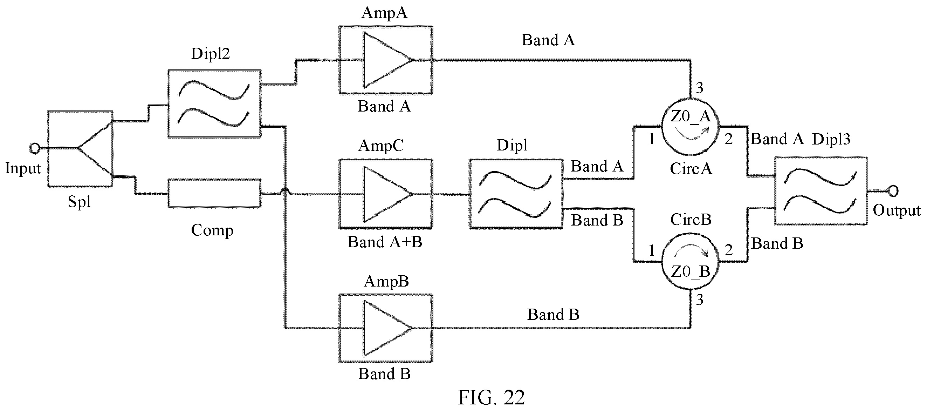

FIG. 22 is a diagram of a single-input single-output radio frequency power amplifier according to an embodiment of this application.

Based on the radio frequency power amplifier provided in FIG. 21, the radio frequency power amplifier provided in this embodiment further includes a third inter-frequency power division circuit Dipl3.

The output end of the first circulator CircA and the output end of the second circulator CircB are respectively connected to a first input end and a second input end of the third inter-frequency power division circuit Dipl3.

The third inter-frequency power division circuit Dipl3 outputs a signal after power combination, to be specific, an output end Output of the third inter-frequency power division circuit Dipl3 outputs a signal after power combination.

The radio frequency power amplifier provided in the foregoing embodiment can work in a frequency division duplexing (FDD, Frequency Division Duplexing) mode and a time division duplex (TDD, Time Division Duplex) mode. For the TDD mode, the following provides descriptions in detail with reference to the accompanying drawings.

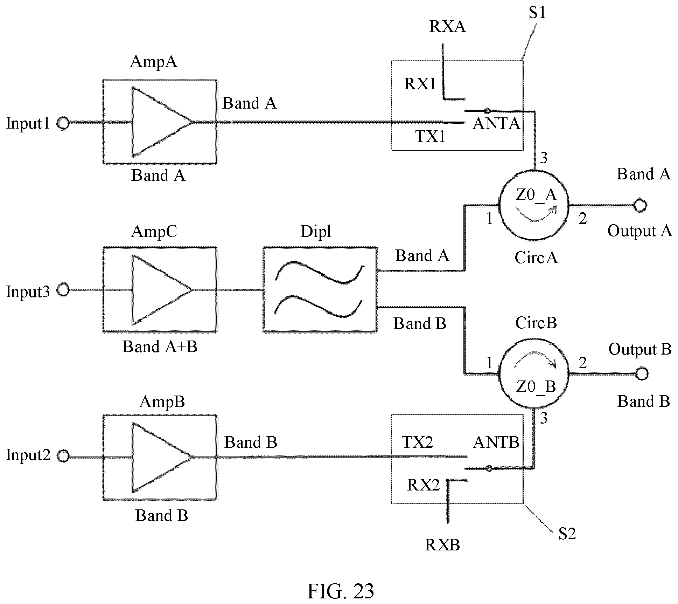

FIG. 23 is a diagram of still another radio frequency power amplifier according to an embodiment of this application.

In FIG. 23, a first switch S1 and a second switch S2 are added based on FIG. 3.

An antenna port ANTA of the first switch S1 is connected to the isolation port 3 of the first circulator CircA, a receive port RX1 of the first switch S1 is connected to a corresponding receive channel RXA, and a transmit port TX1 of the first switch S1 is connected to the output end of the first amplification branch AmpA.

An antenna port ANTB of the second switch S2 is connected to the isolation port 3 of the second circulator CircB, a receive port RX2 of the second switch S2 is connected to a corresponding receive channel RXB, and a transmit port TX2 of the second switch S2 is connected to the second amplification branch AmpB.

It should be noted that antenna ports of the S1 and the S2 may alternatively be referred to as static contacts or non-movable ends from another perspective, and receive ports and transmit ports of the S1 and the S2 may alternatively be referred to as movable contacts or movable ends from another perspective.

In a receiving mode, the antenna port ANTA of the S1 is connected to the receive port RX1, the antenna port ANTB of the S2 is connected to the receive port RX2, the isolation port 3 of the first circulator CircA is connected to the corresponding receive channel RXA, and the isolation port 3 of the second circulator CircB is connected to the corresponding receive channel RXB.

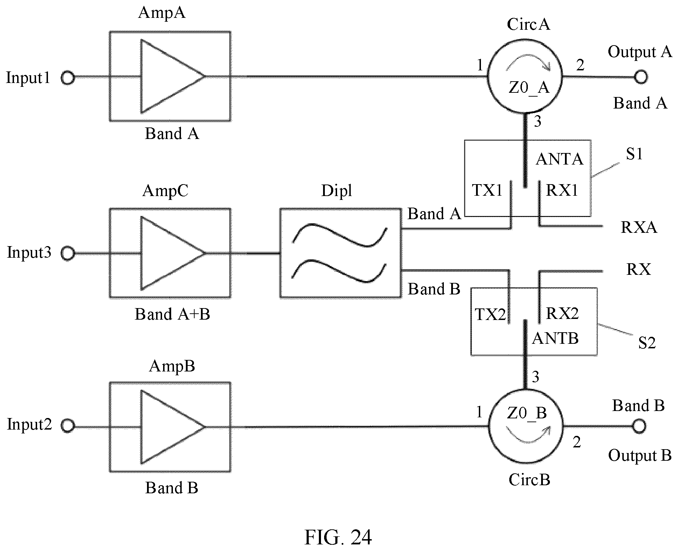

FIG. 23 is described by using an example in which an isolation port of a circulator is connected to an amplification branch. In addition, the isolation port of the circulator may be alternatively connected to an inter-frequency power division circuit. The following describes, with reference to FIG. 24, a corresponding TDD mode implementation when the isolation port is connected to the inter-frequency power division circuit.

FIG. 24 is a diagram of still another radio frequency power amplifier according to an embodiment of this application.

In FIG. 24, a first switch S1 and a second switch S2 are added based on FIG. 4.

An antenna port ANTA of the first switch S1 is connected to the isolation port 3 of the first circulator CircA, a receive port RX1 of the first switch S1 is connected to a corresponding receive channel RXA, and a transmit port TX1 of the first switch S1 is connected to the first output end of the first inter-frequency power division circuit Dipl.

An antenna port ANTB of the second switch S2 is connected to the isolation port 3 of the second circulator CircB, a receive port RX2 of the second switch S2 is connected to a corresponding receive channel RXB, and a transmit port TX2 of the second switch S2 is connected to the second output end of the first inter-frequency power division circuit Dipl.

In a receiving mode, the antenna port ANTA of the S1 is connected to the receive port RX1, the antenna port ANTB of the S2 is connected to the receive port RX2, the isolation port 3 of the first circulator CircA is connected to the corresponding receive channel RXA, and the isolation port 3 of the second circulator CircB is connected to the corresponding receive channel RXB.

Based on the radio frequency power amplifiers provided in the foregoing embodiments, a remote radio unit is further provided in embodiments of this application. Refer to FIG. 1 for details. FIG. 1 is a diagram of a remote radio unit according to an embodiment of this application.

The remote radio unit provided in this embodiment includes the radio frequency power amplifiers described in the foregoing embodiments, and further includes a duplexer 100.

An end of the radio frequency power amplifier is connected to the duplexer 100. Specifically, the duplexer 100 is connected between an antenna feeder system and the radio frequency power amplifier, and the duplexer 100 is connected between the antenna feeder system and a low noise amplifier.

The RRU 1000 includes the radio frequency power amplifier, the low noise amplifier (LNA, Low Noise Amplifier), the duplexer 100, a transmit signal processing unit TX, a receive signal processing unit RX, and a common public radio interface (CPRI, Common Public Radio Interface).

The remote radio unit provided in this embodiment of this application includes the radio frequency power amplifiers described in the foregoing embodiments. The technical solution provided in this application converts a wideband issue into a narrowband issue. Some amplification branches inside the radio frequency power amplifiers are designed for narrowband, to improve efficiency of the PAs. Some amplification branches inside the radio frequency power amplifiers are designed for wideband, to provide the power sharing function. In addition, the narrowband circulator together with the inter-frequency power division circuit performs power combination on the signal output by the wideband amplification branch and the signal output by the narrowband amplification branch, and performs output based on each frequency band. The narrowband isolator may be used at the lower level of each circulator, so that the isolator with the wide bandwidth is not required, and design difficulty of the isolator is reduced.

Based on the radio frequency power amplifiers and the remote radio unit provided in the foregoing embodiments, a base station is further provided in embodiments of this application. The following describes the base station in detail with reference to the accompanying drawing.

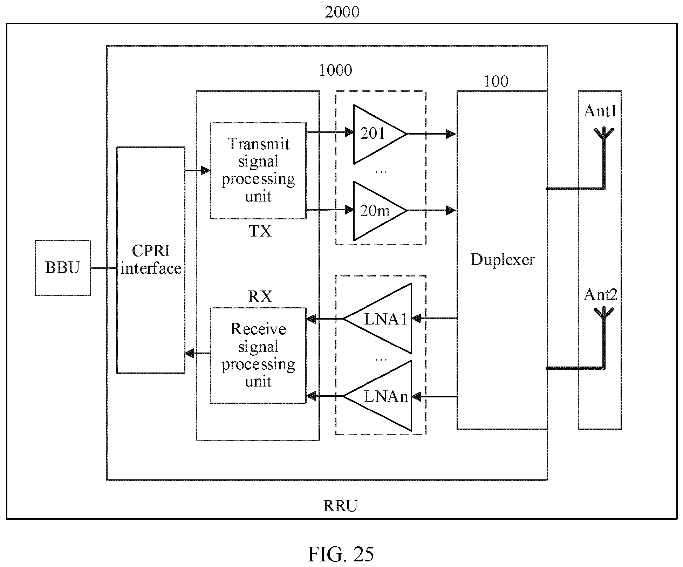

FIG. 25 is a diagram of a base station according to an embodiment of this application.

An embodiment of this application further provides a base station 2000, including the remote radio unit 1000 described in the foregoing embodiments, and further including an antenna feeder system. The antenna feeder system may include a plurality of antennas. The following uses two antennas as an example, to be specific, a first antenna Ant1 and a second antenna Ant2 that are configured to transmit or receive signals.

In addition, the base station 2000 may further include a baseband unit (BBU, Baseband Unit).

As the base station provided in this embodiment of this application includes the radio frequency power amplifiers described in the foregoing embodiments, the base station can implement ultra-wideband signal processing. As signals of a plurality of frequency bands are output, a signal of each frequency band can be processed by an isolator of a corresponding frequency band. Therefore, design difficulty of the isolator can be reduced, and an isolator with a narrow bandwidth can be used for implementation. In addition, the radio frequency power amplifier can achieve a plurality of high-efficiency points, which reduces sizes of lower areas during back-off; and is applicable to a high-power scenario, so that ultra-wideband high-power signal processing can be implemented.

It should be understood that in this application, "at least one (item)" means one or more, and "a plurality of" means two or more. Any simple amendments, equivalent variations, and modifications made to the foregoing embodiments according to the technical essence of this application without departing from the content of the technical solutions of this application shall fall within the protection scope of the technical solutions of this application.

## Claims

1. A radio frequency power amplifier, comprising: a first amplification branch, a second amplification branch, a third amplification branch, a first circulator, a second circulator, and a first inter-frequency power division circuit, wherein
an input end of the first amplification branch is configured to connect to a first path of signal, an input end of the second amplification branch is configured to connect to a second path of signal, and an input end of the third amplification branch is configured to connect to a third path of signal;
an output end of the third amplification branch is connected to an input end of the first inter-frequency power division circuit;
a working frequency band of the first amplification branch and the first circulator is a frequency band A, a working frequency band of the second amplification branch and the second circulator is a frequency band B, and a working frequency band of the third amplification branch is the frequency band A and the frequency band B; and the first inter-frequency power division circuit is configured to output a frequency band A signal and a frequency band B signal;
an output end of the first amplification branch and a first output end of the first inter-frequency power division circuit are respectively connected to different ports of the first circulator, and the first circulator is configured to: perform power combination on a frequency band A signal output by the first amplification branch and the frequency band A signal output by the first inter-frequency power division circuit, and then perform output; and
an output end of the second amplification branch and a second output end of the first inter-frequency power division circuit are respectively connected to different ports of the second circulator, and the second circulator is configured to: perform power combination on a frequency band B signal output by the second amplification branch and the frequency band B signal output by the first inter-frequency power division circuit, and then perform output.

2. The radio frequency power amplifier according to claim 1, wherein the output end of the first amplification branch is connected to an isolation port of the first circulator, and the first output end of the first inter-frequency power division circuit is connected to an input port of the first circulator; and
the output end of the second amplification branch is connected to an isolation port of the second circulator, and the second output end of the first inter-frequency power division circuit is connected to an input port of the second circulator.

3. The radio frequency power amplifier according to claim 1, wherein the output end of the first amplification branch is connected to an input port of the first circulator, and the first output end of the first inter-frequency power division circuit is connected to an isolation port of the first circulator; and
the output end of the second amplification branch is connected to an input port of the second circulator, and the second output end of the first inter-frequency power division circuit is connected to an isolation port of the second circulator.

4. The radio frequency power amplifier according to claim 1, wherein the output end of the first amplification branch is connected to an input port of the first circulator, and the first output end of the first inter-frequency power division circuit is connected to an isolation port of the first circulator; and
the output end of the second amplification branch is connected to an isolation port of the second circulator, and the second output end of the first inter-frequency power division circuit is connected to an input port of the second circulator.

5. The radio frequency power amplifier according to claim 1, wherein the output end of the first amplification branch is connected to an isolation port of the first circulator, and the first output end of the first inter-frequency power division circuit is connected to an input port of the first circulator; and
the output end of the second amplification branch is connected to an input port of the second circulator, and the second output end of the first inter-frequency power division circuit is connected to an isolation port of the second circulator.

6. The radio frequency power amplifier according to any one of claims 1 to 5, wherein the first amplification branch, the second amplification branch, and the third amplification branch each are any one of the following:
a single-transistor power amplifier, a Doherty power amplifier, a Chireix power amplifier, a timing Doherty power amplifier, a load modulated balanced amplifier LMBA, or a circulator load modulated amplifier CLMA.

7. The radio frequency power amplifier according to claim 6, wherein the first amplification branch, the second amplification branch, and the third amplification branch each comprise a single-transistor power amplifier, wherein
the single-transistor power amplifier comprised in the first amplification branch is a first carrier power amplifier;
the single-transistor power amplifier comprised in the second amplification branch is a second carrier power amplifier; and
the single-transistor power amplifier comprised in the third amplification branch is a peak power amplifier.

8. The radio frequency power amplifier according to claim 6, wherein the first amplification branch and the second amplification branch each comprise the Doherty power amplifier, and the third amplification branch comprises the single-transistor power amplifier; and the single-transistor power amplifier comprised in the third amplification branch is a peak power amplifier.

9. The radio frequency power amplifier according to claim 6, wherein the first amplification branch, the second amplification branch, and the third amplification branch each comprise the Doherty power amplifier.

10. The radio frequency power amplifier according to any one of claims 1 to 9, further comprising: a second inter-frequency power division circuit, a power splitter, and a phase compensation network, wherein
a first output end of the power splitter is connected to an input end of the second inter-frequency power division circuit, a first output end and a second output end of the second inter-frequency power division circuit are respectively connected to the first amplification branch and the second amplification branch, a second output end of the power splitter is connected to a first end of the phase compensation network, and a second end of the phase compensation network is connected to the third amplification branch.

11. The radio frequency power amplifier according to any one of claims 1 to 10, further comprising a third inter-frequency power division circuit, wherein
an output end of the first circulator and an output end of the second circulator are respectively connected to a first input end and a second input end of the third inter-frequency power division circuit; and
the third inter-frequency power division circuit outputs a signal obtained through power combination.

12. The radio frequency power amplifier according to any one of claims 1 to 10, further comprising: a fourth amplification branch and a third circulator, wherein
the third amplification branch works on the frequency band A, the frequency band B, and a frequency band C;
an input end of the fourth amplification branch is configured to connect to a fourth path of signal;
an output end of the fourth amplification branch and a third output end of the first inter-frequency power division circuit are respectively connected to different ports of the third circulator, and the first inter-frequency power division circuit is further configured to output a frequency band C signal; and
the third circulator is configured to: perform power combination on a frequency band C signal output by the fourth amplification branch and the frequency band C signal output by the first inter-frequency power division circuit, and then perform output.

13. The radio frequency power amplifier according to any one of claims 1 to 12, further comprising a first switch and a second switch, wherein
an antenna port of the first switch is connected to the isolation port of the first circulator, a receive port of the first switch is connected to a corresponding receive channel, and a transmit port of the first switch is connected to the output end of the first amplification branch; and
an antenna port of the second switch is connected to the isolation port of the second circulator, a receive port of the second switch is connected to a corresponding receive channel, and a transmit port of the second switch is connected to the second amplification branch.

14. The radio frequency power amplifier according to any one of claims 1 to 12, further comprising a first switch and a second switch, wherein
an antenna port of the first switch is connected to the isolation port of the first circulator, a receive port of the first switch is connected to a corresponding receive channel, and a transmit port of the first switch is connected to the first output end of the first inter-frequency power division circuit; and
an antenna port of the second switch is connected to the isolation port of the second circulator, a receive port of the second switch is connected to a corresponding receive channel, and a transmit port of the second switch is connected to the second output end of the first inter-frequency power division circuit.

15. A remote radio unit, comprising the radio frequency power amplifier according to any one of claims 1 to 14, and further comprising a duplexer, wherein
an end of the radio frequency power amplifier is connected to the duplexer.

16. A base station, comprising the remote radio unit according to claim 15, and further comprising an antenna, wherein
the remote radio unit is connected to the antenna; and
the remote radio unit is configured to process received and transmitted signals of the antenna.
